# EUROPÄISCHE PATENTSCHRIFT

(11) **EP 1 480 500 B1**
(45) Veröffentlichungstag und Bekanntmachung des Hinweises auf die Patenterteilung: **16.05.2007**
(21) Anmeldenummer: 03011229.6
(22) Anmeldetag: 16.05.2003
(51) Int. Cl.: H05K 1/14, H05K 1/16

(54) **Leistungsversorgungsschaltung mit dreidimensional angeordneten Schaltungsträgern sowie Herstellungsverfahren**
Power supply circuit with three dimensionally arranged circuit boards and method of manufacture
Circuit d'alimentation en puissance avec supports de circuits tridimensionnelles ainsi que methode de fabrication

(43) Veröffentlichungstag der Anmeldung: 24.11.2004
(73) Patentinhaber: Friwo Mobile Power GmbH, 48346 Ostbevern (DE)
(72) Erfinder: Bothe, Michael, 48163 Münster (DE); Mörbe, Stefan, 49205 Hasbergen (DE); Becks, Michael, 48291 Telgte (DE); Grad, Peter, 48161 Münster (DE)
(74) Vertreter: Grünecker, Kinkeldey, Stockmair & Schwanhäusser Anwaltssozietät

(56) Entgegenhaltungen:
- EP-A- 0 814 518
- DE-A- 10 030 605
- DE-C- 3 839 505
- US-A- 4 712 160
- US-A- 5 990 421
- US-A1- 2001 008 479
- US-B1- 6 454 604
- BOTHE M: "3D-PACKAGING BEI STROMVERSORGUNGEN" F & M. FEINWERKTECHNIK MIKROTECHNIK MESSTECHNIK, CARL HANSER GMBH, MUNCHEN, DE, Bd. 101, Nr. 4, 1. April 1993 (1993-04-01), Seiten 111-113, XP000360796 ISSN: 0944-1018

## Beschreibung

Die vorliegende Erfindung bezieht sich auf eine Leistungsversorgungsschaltung mit mindestens einem Wandler, der mit einem primärseitigen Schaltkreis und mit einem sekundärseitigen Schaltkreis verbunden ist. Die Erfindung bezieht sich außerdem auf ein Verfahren zum Herstellen einer solchen Leistungsversorgungsschaltung.

Leistungsversorgungsschaltungen, wie beispielsweise DC-Stromversorgungen, werden heutzutage als lineare 50 Hz-Transformatoren oder als Schaltnetzteile mit Schaltfrequenzen in einem Bereich von einigen Kilohertz bis in den Megahertzbereich ausgeführt. Dabei wird allgemein versucht, das Volumen der Schaltung und damit des Gerätes zu verringern, um insbesondere bei Ladegeräten für mobile Anwendungen die Benutzerfreundlichkeit zu erhöhen. Mit der Ausführung als Schaltnetzteil und dem damit einhergehenden Wegfall des relativ großen und schweren 50 Hz-Transformators ist ein erster Schritt zu einer Verkleinerung gelungen.

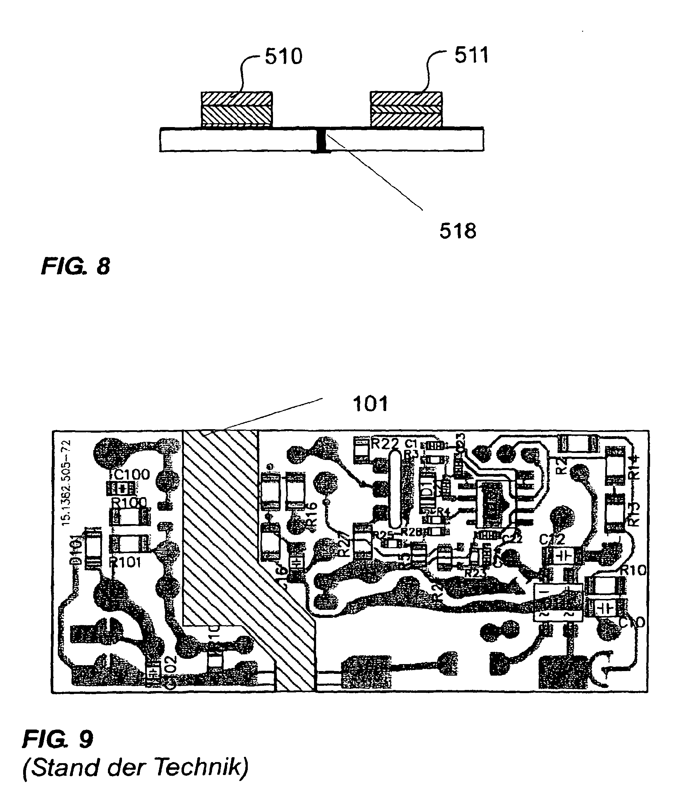

Mit den derzeitigen Ausführungsformen der Stromversorgungsschaltungen, bei denen eine zweidimensionale Leiterplatte gemäß Fig. 9 eingesetzt wird und entsprechende Steckergehäuse und Ausgangsleitungen verwendet werden, sind der Miniaturisierung jedoch enge Grenzen gesetzt. Beispielsweise ist eine Integration in das zu versorgende Gerät, den Verbraucher, in den meisten Fällen nicht möglich. Die Leistungsdichte heutiger Kleinleistungsnetzteile liegt bei ca. 0,12-0,18 W/cm³ (ca. 2 bis 3 W/Inch³).

Weiterhin steht einer Miniaturisierung die Verwendung konventioneller diskreter Bauteile, wie beispielsweise Elektrolytkondensatoren oder diskrete Widerstände, entgegen. Solche Bauteile haben bestimmte minimale Abmessungen, die auch nicht durch Verringern der charakteristischen Werte dieses Bauteils unterschritten werden können. Eine Alternative, die kleinere Abmessungen erlaubt, wäre wünschenswert.

Aus der internationalen Patentanmeldung WO 99/43074 ist eine Anordnung bekannt, bei der eine Schaltung zur Wandlung von Netzspannung in Niederspannung in einem Ausgangsstecker der Leistungsversorgungsvorrichtung untergebracht ist. Bisher realisierte Stromversorgungsschaltungen haben jedoch ein zu großes Volumen, um diese Anordnung tatsächlich benutzerfreundlich verwirklichen zu können. Für den Einsatz in einem derartigen Gerät wäre daher eine entsprechende Miniaturisierung der Stromversorgungsschaltung nötig.

Bei der bekannten Bauform des Steckernetzgerätes mit Ausgangsleitung ergibt sich eine nicht zu vermeidende Verlustleistung auf der Ausgangsleitung, da ausgangsseitig ein relativ hoher Strom vorhanden ist und die Ausgangsleitung nicht mit einem beliebig großen Querschnitt ausgeführt werden kann, um den ohmschen Widerstand entsprechend zu verringern. Die Ausgangsspannung wird beispielsweise, wie in der DE 100 18 229 A1 gezeigt, primärseitig geregelt, so dass sekundärseitig nur wenige Bauteile benötigt werden. Bei dieser Anordnung ergibt sich zwangläufig ein lastabhängiger Spannungsabfall auf der Sekundärleitung. Damit entsteht eine nicht zu vermeidende Ungenauigkeit in der Ausgangsspannung am Ausgangsstecker, da der Spannungsabfall auf der Leitung im Betrieb nicht gemessen werden kann und somit nicht für die Regelung der Ausgangsspannung zur Verfügung steht. Durch den Verzicht auf die Ausgangsleitung, der bei entsprechender Miniaturisierung und Unterbringung der Schaltung im Ausgangsstecker des Gerätes entsprechend der WO 99/43074 möglich ist, würde dieser Nachteil eliminiert werden.

Weiterhin müssen, um eine normgerechte galvanische Trennung der Primär- und Sekundärschaltung zu gewährleisten, auf dem Schaltungsträger Luft- und Kriechstrecken eingehalten werden. Bei einer zweidimensionalen Leiterplatte, wie sie in Fig. 9 dargestellt ist, bedingt dies immer einen großen Abstand zwischen den Bauteilen der Primärseite und denen der Sekundärseite. Auf der in Fig. 9 mit dem Bezugszeichen 101 gekennzeichneten Fläche dürfen daher keine Bauteile platziert werden. Der Abstand muss beispielsweise bei Anwendung der Norm EN60950 mindestens 6,4 mm betragen, wenn die Netzspannung 230 Volt beträgt. Es besteht daher ein Bedürfnis, eine größere Flexibilität bei der Ausbildung der Luft- und Kriechstrecken zu ermöglichen.

Aus der US 4,712,160 ist ein Leistungsmodul bekannt, bei dem die primärseitige Leiterplatte und die sekundärseitige Leiterplatte parallel zueinander und räumlich getrennt durch Isolationsschichten und den dazwischen angeordneten Transformator aufgebaut sind. Die beiden Leiterplatten sowie der Wandler werden durch eine Vergussmasse miteinander mechanisch verbunden.

Aus der US 6,454,604 ist ein Steckemetzteil bekannt, bei dem eine primärseitige Leiterplatte und eine sekundärseitige Leiterplatte separat aufgebaut sind. Beide Leiterplatten befinden sich in unterschiedlichen, aber zueinander parallel verlaufenden Ebenen.

Aus der US 5,990,421 ist eine gedruckte Leiterplatte bekannt, die mit einer Schicht aus einem Widerstandsmaterial versehen ist, welche einen integrierten Widerstand bilden kann. Dieser integrierte Widerstand kann mittels eines Siebdruckverfahrens in integrierter Weise in dem Schaltungsträger aufgebaut werden.

Eine Leiterplatte, in der neben Widerstandsstrukturen auch Kondensatoren integriert sind, ist in der US 2001/0008479A1 offenbart.

Die EP 0 814 518A zeigt ein piezoelektrisches Wandlerelement, das auf einer Leiterplatte montiert ist und von einer umhüllenden Folie umgeben ist. Die elektrische Kontaktierung erfolgt dabei über einen flexiblen Flachleiter, der zwischen dem Transformatorelement und der Leiterplatte eingeschoben ist.

Die DE 100 30 605A1 offenbart ein Schaltnetzteil mit einem Kondensator und einem Transformator mit mehreren Wicklungen, wobei der Kondensator in den Transformator dadurch integriert ist, dass durch dielektrische Folien gegeneinander isolierte Elektroden zu einer Spulenwicklung gewickelt werden.

Die Aufgabe, die der vorliegenden Erfindung zugrunde liegt, besteht daher darin, eine verbesserte Leistungsversorgungsschaltung anzugeben, die eine verringerte Baugröße und erhöhte Leistungsdichte aufweist sowie eine höhere Flexibilität bei der Ausbildung der Sicherheitsabstände zwischen Primär- und Sekundärseite bietet.

Diese Aufgabe wird durch die Gegenstände der unabhängigen Patentansprüche gelöst. Vorteilhafte Weiterbildungen der vorliegenden Erfindung sind Gegenstand der abhängigen Patentansprüche.

Die vorliegende Erfindung basiert auf dem Grundgedanken, die Schaltung in einzelne Teilschaltungen zu unterteilen und die verschiedenen benötigten Bauelemente auf separaten Schaltungsträgern anzubringen oder in diese zu integrieren. Diese Schaltungsträger sind erfindungsgemäß in mindestens zwei verschiedenen Ebenen angeordnet, die entweder parallel zueinander oder quer zueinander verlaufen können. Damit kann die Leistungsdichte wesentlich verbessert werden und neue Anwendungen in Umgebungen, bei denen die Größe oder der Formfaktor eine entscheidende Rolle spielen, sind möglich. Durch eine solche dreidimensionale Anordnung der separaten Schaltungsträger, wobei unter dreidimensional verstanden wird, dass die Schaltungsträger in Schichten angeordnet und gestapelt und/oder quer zueinander angeordnet werden, kann die Leistungsdichte vervielfacht werden. Weiterhin ergeben sich verbesserte Möglichkeiten zur Ausbildung der Luft- und Kriechstrecken durch Ausnutzung der dritten Dimension.

Im einfachsten Fall werden der primärseitige Schaltkreis und der sekundärseitige Schaltkreis auf jeweils einem separaten Schaltungsträger angeordnet, die mechanisch und elektrisch miteinander gekoppelt sind, und diese Schaltungsträger werden in zwei verschiedenen Ebenen angeordnet. Um jedoch eine noch weitere Miniaturisierung zu erreichen, kann jeder der beiden Schaltkreise nochmals unterteilt und auf Teilschaltungsträgem untergebracht werden.

Gemäß einer vorteilhaften Ausführungsform verläuft die durch den sekundärseitigen Schaltungsträger definierte Ebene im Wesentlichen quer zu der durch den primärseitigen Schaltungsträger definierten Ebene. Diese Anordnung erlaubt bei gleichzeitig äußerst geringem Raumbedarf eine besonders große räumliche Beabstandung zwischen dem primärseitigen und dem sekundärseitigen Schaltkreis.

Unterteilt man die primärseitige Schaltung in verschiedene Teilschaltungen, die auf einer Vielzahl von primärseitigen Schaltungsträgern, deren Ebenen im Wesentlichen parallel zueinander verlaufen, aufgebaut sind, kann eine außerordentliche räumliche Kompaktheit erreicht werden. Bei dieser Anordnung kann insbesondere im Falle einer quer zu diesen Schaltungsträgerebenen verlaufenden sekundärseitigen Schaltungsträgerebene der durch den sekundärseitigen Schaltungsträger vorgegebene Platzbedarf besonders effizient genutzt werden.

Eine besonders gute Durchschlagfestigkeit und elektrische Sicherheit kann erreicht werden, indem der mindestens eine primärseitige Schaltungsträger durch eine elektrisch isolierende Schicht, beispielsweise eine Kunststoffschicht, von dem mindestens einen sekundärseitigen Schaltungsträger getrennt ist.

Die Verwendung integrierter Schaltungsträger, wie beispielsweise zur Integration von Widerständen, die vorzugsweise in Dickschichttechnologie herstellbar sind, erlaubt eine leichte Herstellbarkeit bei gleichzeitig großer Miniaturisierung. Eine besonders platzsparende Anordnung kann erreicht werden, indem integrierte Kondensatoren mit mittlerer oder hoher Spannungsfestigkeit in den jeweiligen Schaltungsträger eingebettet werden.

Solche integrierten Kondensatoren können je nach den elektrischen Anforderungen als Monolayerstruktur oder Multilayerstruktur hergestellt werden. Alternativ können auch integrierte Kondensatoren, die durch ein Verfahren hergestellt werden, bei dem eine Vorstufe des Dielektrikums in entsprechende, teilweise metallisierte Öffnungen eines Schaltungsträgers eingebracht wird, eingesetzt werden. Derartige integrierte Kondensatoren sind in der deutschen Patentanmeldung DE 103 02 104.3 (veröffentlicht am 05.08.2004) gezeigt.

Zur Anpassung der elektrischen Eigenschaften an bestimmte anwendungsspezifische Vorgaben kann auch die Verwendung diskreter aktiver und/oder passiver Bauelemente vorgesehen sein. Insbesondere die Robustheit und die leichte, kostengünstige Herstellbarkeit zählen zu den Vorteilen solcher diskreter Bauelemente.

Entsprechend der an die Leistungsversorgungsschaltung gestellten äußeren Anforderungen kann als Wandler entweder ein magnetischer oder ein piezoelektrischer Wandler eingesetzt werden. Herkömmliche elektromagnetische Transformatoren bieten den Vorteil einer kostengünstigen Herstellbarkeit und einfacheren elektronischen Ansteuerung. Demgegenüber stellen piezoelektrische Spannungswandler die Alternative mit dem größten Miniaturisierungspotential dar, da piezoelektrische Spannungswandler nur ca. ein Fünftel der Bauhöhe eines elektromagnetischen Wandlers beanspruchen.

Durch die Verwendung eines keramischen Werkstoffs als Schaltungsträger wird eine verbesserte Wärmeableitung von sich im Betrieb erhitzenden Bauteilen gewährleistet. Daher können diese Bauteile ohne weiteren Kühlkörper nahe aneinander angeordnet werden, was ebenfalls zur Miniaturisierung beiträgt.

Zur Sicherung der mechanischen Stabilität und elektrischen Kontaktierung auch unter Umwelteinflüssen, wie Erschütterungen und Temperaturwechsel, können die einzelnen Schaltungsträger mittels eines gemeinsamen Sinterns, Klebens oder Verlötens miteinander mechanisch verbunden sein.

Zur effizienten Herstellung der benötigten elektrischen Verbindungen zwischen separaten Schaltungsträgern können, vor allem, wenn die Schaltungsträger in einer gestapelten Anordnung übereinander angeordnet sind, Durchkontaktierungen (sogenannte "Vias") in Isolationsschichten vorgesehen sein.

Um die vorgeschriebenen Luft- und Kriechstrecken zu verringern und damit den Gesamtaufbau noch kompakter zu gestalten, kann die gesamte Schaltung in einer elektrisch isolierenden Umhüllung, beispielsweise durch ein Vergießen, eingebettet sein.

Gemäß einer weiteren vorteilhaften Ausführungsform können Bauteile in dem Wandler-Spulenkörper oder der Wandlerhalterung integriert sein. Dies geschieht beispielsweise durch die Verwendung von Aufbau- und Verbindungstechniken wie 3D-MID (dreidimensionales Molded Interconnect Device) oder einem Leadframe. Der Leadframe oder das 3D-MID-Bauteil können gleichzeitig eine Kontaktierung zur Grundleiterplatte, den Ausgangskontakt, beinhalten.

Anhand der in den beiliegenden Zeichnungen dargestellten vorteilhaften Ausgestaltungen wird die Erfindung im Folgenden näher erläutert. Ähnliche oder korrespondierende Einzelheiten des erfindungsgemäßen Gegenstands sind mit denselben Bezugszeichen versehen. Es zeigen:
- **Fig. 1**: eine schematische Schnittdarstellung durch eine Leistungsversorgungsschaltung gemäß einer ersten Ausführungsform;
- **Fig. 2**: eine Leistungsversorgungsschaltung gemäß einer zweiten Ausführungsform;
- **Fig. 3**: einen Ausschnitt aus der Leistungsversorgungsschaltung gemäß Fig. 1;
- **Fig. 4**: einen weiteren Ausschnitt aus der Leistungsversorgungsschaltung gemäß der Fig. 1;
- **Fig. 5**: eine schematische Schnittdarstellung eines Schaltungsträgers mit integrierten Kondensatoren gemäß einer ersten Ausführungsform;
- **Fig. 6**: eine schematische Schnittdarstellung eines Schaltungsträgers mit integrierten Kondensatoren gemäß einer zweiten Ausführungsform;
- **Fig. 7**: eine schematische Schnittdarstellung eines Schaltungsträgers mit integrierten Kondensatoren gemäß einer dritten Ausführungsform;
- **Fig. 8**: eine schematische Schnittdarstellung eines Schaltungsträgers mit integrierten Kondensatoren gemäß einer vierten Ausführungsform;
- **Fig. 9**: den Schaltungsträger einer Leistungsversorgungsschaltung nach dem Stand der Technik.

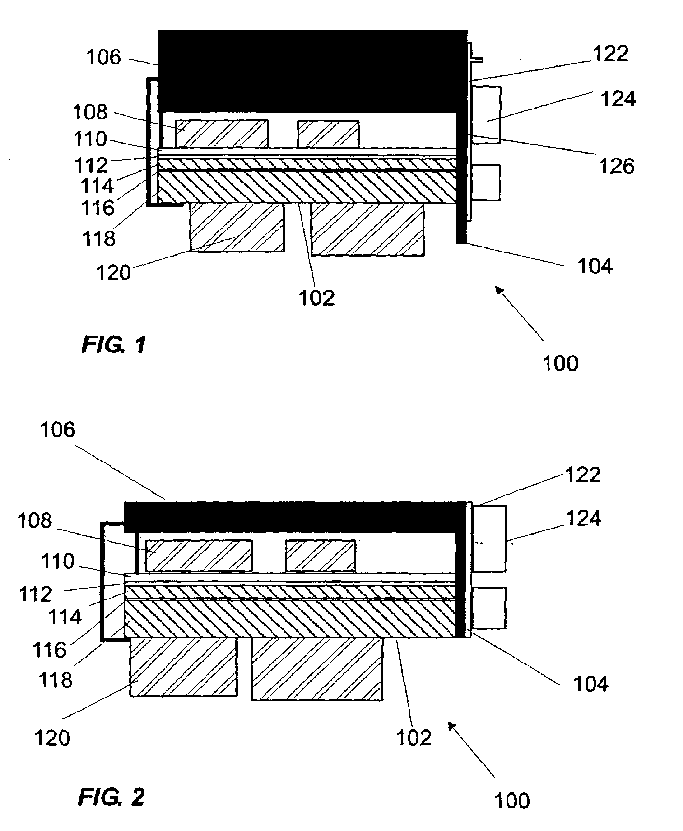

Mit Bezug auf Fig. 1 soll nunmehr eine Ausführungsform einer Leistungsversorgungsschaltung gemäß der vorliegenden Erfindung erläutert werden. Die Leistungsversorgungsschaltung 100 umfasst dabei einen Wandler 106, der piezoelektrisch oder magnetisch sein kann, sowie eine mit dem Eingang des Wandlers 106 verbundene primärseitige Schaltung 102. In der hier gezeigten Ausführungsform ist der 106 Wandler ein herkömmlicher elektromagnetischer Wandler mit einem vergleichsweise großen Spulenkörper. Die sekundärseitige Schaltung 104 ist an dem Spulenkörper mechanisch fixiert und elektrisch mit dem Ausgang des Wandlers 106 verbunden. Die primärseitige Schaltung 102 und die sekundärseitige Schaltung 104 sind erfindungsgemäß auf unterschiedlichen Schaltungsträgern 122, 110, 114 und 118 angeordnet. Dabei sind die einzelnen Schichten der primärseitigen Schaltung 102 im Wesentlichen quer zu der Ebene der sekundärseitigen Schaltung 104 angeordnet.

Die primärseitige Schaltung 102 ist darüber hinaus auf verschiedene parallel zueinander gestapelte Schaltungsträger 110, 114 und 118 verteilt. Um optimale elektrische Eigenschaften bei gleichzeitig hoher Leistungsdichte zu realisieren, werden auf der Primärseite diskrete und integrierte Bauelemente kombiniert. Die diskreten Bauteile 108 der Primärseite sind hierbei auf einer Keramik 110 aufgebracht, die integrierte Widerstände enthalten kann. Derartige integrierte Widerstände können z. B. mit Hilfe der Dickschichttechnologie auf einem Keramiksubstrat verwirklicht werden. Als Keramiksubstrat wird oftmals Aluminiumoxid verwendet, was den Vorteil einer guten Wärmeleitfähigkeit und einer hohen Isolationsfestigkeit bietet.

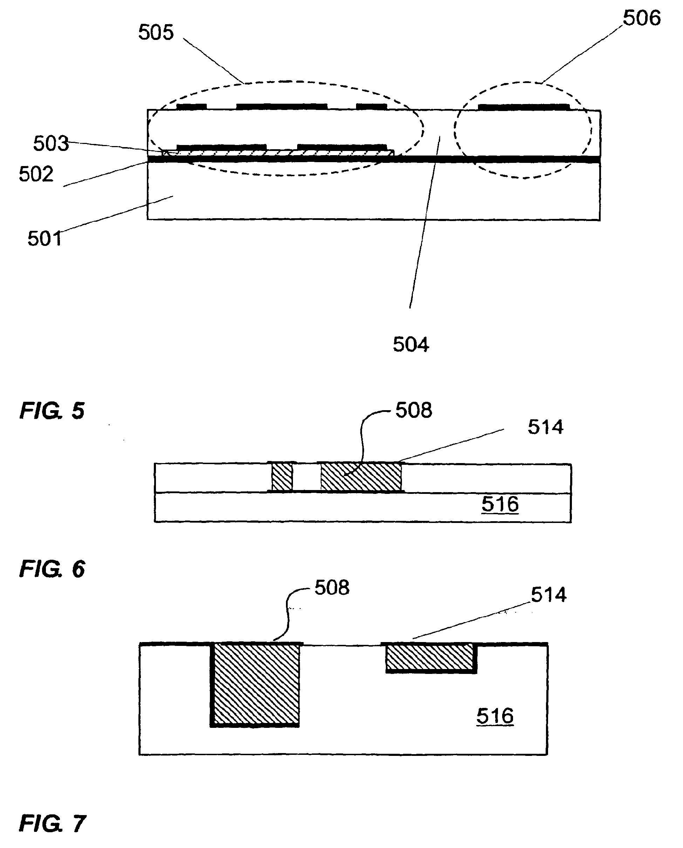

Eine Isolationsschicht 112, in der (hier nicht explizit dargestellt) Durchkontaktierungen für die elektrische Verbindung vorgesehen sind, koppelt den Schaltungsträger 110 mit einem Schaltungsträger 114, der integrierte Kondensatoren mit mittlerer Spannungsfestigkeit enthält. Eine Massemetallisierung 116 ist in Kontakt mit dem Schaltungsträger 118, der integrierte Kondensatoren mit hoher Spannungsfestigkeit enthält, wie sie z. B. für einen Teil des Eingangsfilters benötigt werden. Derartige integrierte Kondensatoren sollen später mit Bezug auf die Figuren 5 bis 8 genauer erläutert werden. Auf dem Schaltungsträger 118 sind weitere für das Eingangsfilter der Primärseite benötigte Bauteile 120 in diskreter Bauform aufgebracht.

Auf der Sekundärseite wird als Schaltungsträger in der vorliegenden Ausführungsform ein Leadframe 122 verwendet, auf dem diskrete Bauteile 124 angeordnet sind. Es kann aber auch ein sogenanntes Molded Interconnect Device (MID) eingesetzt werden.

Eine Isolierung 126 stellt die benötigte elektrische Isolation zwischen der Hybridleiterplatte der Primärseite 102 und dem Leadframe 122 der Sekundärseite her.

Die Anordnung der gezeigten Schichten kann in beliebiger Reihenfolge erfolgen. Die in der Fig. 1 gezeigte Lösung bietet jedoch den Vorteil, dass die Reihenfolge der Schichten in etwa dem Stromlaufplan von der Eingangsseite zur Ausgangsseite folgt. Die Bauteile der Sekundärseite können entweder parallel zu den Schichten der Primärseite angeordnet sein oder, wie hier gezeigt, mit in den Spulenkörper des Transformators 106 integriert sein. Ebenso wie die Bauteile der Primärseite können auch die Bauteile der Sekundärseite auf mehrere Schichten verteilt angeordnet werden. Der Bauteilträger für die diskreten Bauteile der Sekundärseite kann entweder als Leadframe 122 ausgeführt sein oder direkt, im Falle eines magnetischen Wandlers, Teil des Spulenkörpers sein. Im Falle eines piezoelektrischen Wandlers kann der Bauteilträger in die Wandlerhalterung integriert sein.

Die elektrische Verbindung zwischen den Bauteilen der einzelnen Schichten erfolgt durch sogenannte Vias, d.h. Durchkontaktierungen, innerhalb der einzelnen Schichten, die aber der Übersichtlichkeit halber hier nicht dargestellt sind.

Eine weitere Ausführungsform, in der als Wandler 106 ein piezoelektrischer Wandler vorgesehen ist, zeigt Fig. 2. Man erkennt im Vergleich zur Fig. 1 die wesentlich geringere Bauhöhe des piezoelektrischen Wandlers 106, die nur etwa ein Fünftel der Bauhöhe des Spulenkörpers ausmacht.

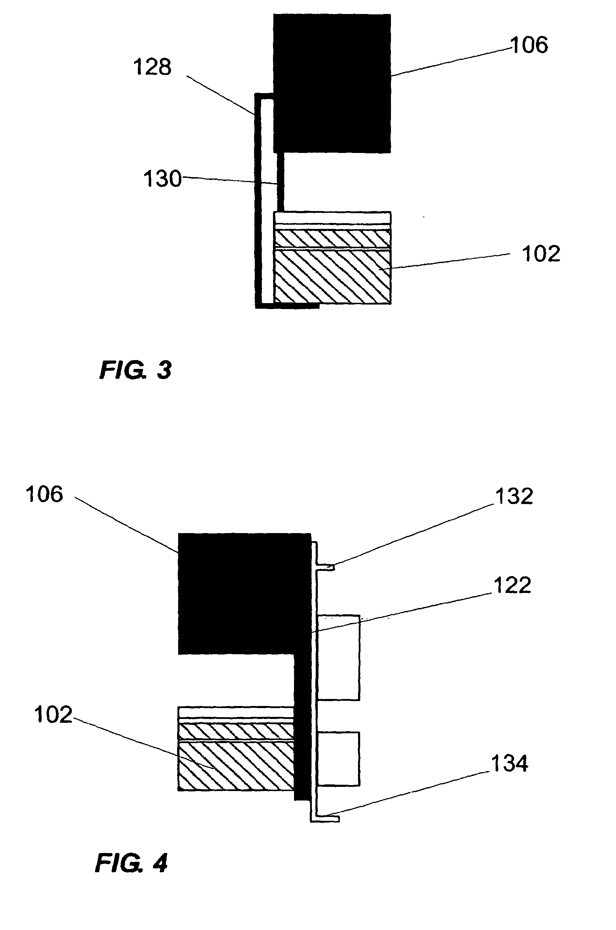

In Fig. 3 ist ein Ausschnitt der Fig. 1 gezeigt, der die Kontaktierung des Wandlers 106 mit der primärseitigen Hybridleiterplatte 102 darstellt. Der Spulenkörper des Wandlers 106 ist in der vorliegenden Ausführungsform so konstruiert, dass eine Kontaktierung sowohl auf die Oberseite wie auch auf die Unterseite der Hybridleiterplatte 102 erfolgen kann.

Fig. 4 zeigt einen Ausschnitt aus der Fig. 1, der die Isolation zwischen der Hybridleiterplatte 102 der Primärseite und dem Leadframe 122 der Sekundärseite verdeutlicht. Hier ist in einer alternativen Ausführungsform der Leadframe 122 direkt als elektrischer Kontakt für eine Grundleiterplatte ausgeführt. Dabei bezeichnet das Bezugszeichen 134 das entsprechende Kontaktierungspad für die Grundleiterplatte. An dem Leadframe 122 ist außerdem ein Anwickelpunkt 132 für die Wandlerspule 106 angeformt.

Für die Herstellung der auf der Primärseite und der Sekundärseite benötigten Kondensatoren können die verschiedensten Technologien eingesetzt werden. Für einige als diskrete Bauteile realisierte Kondensatoren mit hohen Kapazitäten können aus Preisgründen gewickelte Elektrolytkondensatoren verwendet werden. Weiterhin können neben Tantalkondensatoren auch Keramikkondensatoren eingesetzt werden.

Keramikkondensatoren haben den Vorteil, dass sie zum einen verbesserte Hochfrequenzeigenschaften haben und zum anderen einen kleinen Ersatzserienwiderstand auch bei hoher Strombelastbarkeit aufweisen. Um eine ausreichende Kapazität bei kleiner Fläche zu erreichen, werden diese Kondensatoren vielfach in Mehrlagentechnik (MLC) hergestellt.

Eine weitere bekannte Möglichkeit zur Herstellung derartiger Keramikkondensatoren besteht in der Ausbildung durch eine Monolayerstruktur, bei der nur eine einzige Schicht dielektrisches Material verwendet wird. Dadurch ergibt sich eine einfache Herstellungsweise. Da die Paneldicke aus Gründen der mechanischen Stabilität mindestens 0,2 mm sein muss, ergibt sich eine hohe Spannungsfestigkeit.

Eine weitere Realisierungsmöglichkeit sind sogenannte Multilagenbauelemente, bei denen viele Lagen (bis zu 300) von dielektrischem Material gestapelt und gesintert werden. Zwischen den einzelnen Lagen befinden sich Elektroden. Mit diesem Verfahren sind hohe Kapazitätswerte erreichbar, wobei die Spannungsfestigkeit über den Abstand der einzelnen Lagen zueinander eingestellt werden kann. Bei höherer Spannungsfestigkeit ergibt sich bei gleicher Baugröße eine geringere Kapazität, da die Lagen dicker werden.

Um eine größtmögliche Miniaturisierung bei der Anwendung in netzbetriebenen Stromversorgungen zu erreichen, werden derartige Kondensatoren in dem eigentlichen Schaltungsträger integriert aufgebaut. Ein Beispiel für einen in dem Schaltungsträger integrierten Mehrlagenkondensator ist in der US-Patentanmeldung US2001/0008479 A1 gezeigt. Hier wird in einer Aussparung des Schaltungsträgers ein Mehrlagenkondensator ausgebildet, der durch anschließendes Pressen und Sintern mit dem Substrat fest verbunden wird.

Eine mögliche Realisierungsform für integrierte Kondensatoren ist in der Fig. 5 dargestellt. Beispielhaft ist ein Dielektrikum 504 ein Kondensator für den Niedervoltbereich ohne Massebezug 505 und ein Kondensator mit Massebezug 506, ebenfalls für den Niedervoltbereich, integriert. Die Schicht 501 enthält einen Multilayer-Kondensator, der eine hohe Kapazität aufweist und für hohe Spannungen ausgelegt ist. Die Massemetallisierung 502 ist zwischen die beiden Kondensatorebenen eingefügt. Zur Isolation gegenüber dem Massepotential für den Kondensator 505 ist eine Passivierungsschicht 503 vorgesehen.

Die Figuren 6 bis 8 zeigen weitere mögliche Realisierungsformen für integrierte Kondensatoren entsprechend der deutschen Patentanmeldung DE 103 02 104.3, bei denen ein Dielektrikum 508 in entsprechende Öffnungen eines isolierenden Substrats 516 eingebettet ist. Metallisierungen 514 sorgen für die benötigten elektrischen Anschlüsse. Bei der Herstellung dieser Strukturen wird zunächst eine Vorstufe des Dielektrikums 508 in die, gegebenenfalls metallisierte, Öffnung eingebracht und anschließend durch einen Press- und Sinterprozess in den Endzustand umgewandelt. Voneinander separierte Einzelkondensatoren 510, 511 können durch anschließendes Entfernen umgebender Schichten erreicht werden (Fig. 8). In der Fig. 8 ist außerdem beispielhaft eine Realisierungsmöglichkeit für ein Via 518 gezeigt.

Für die Herstellung integrierter Kondensatoren und passiver Bauelemente kommen selbstverständlich alle möglichen anderen Verfahren z. B. auch die Verwendung von sogenannten LTCC (low temperature co-fired ceramics), in Frage.

Im Folgenden soll nunmehr die Herstellung einer erfindungsgemäßen Leistungsversorgungsschaltung im Detail beschrieben werden.

Zu Herstellung der erfindungsgemäßen Leistungsversorgungsschaltung, wie sie beispielsweise in Fig. 1 dargestellt ist, werden zunächst die primärseitige und die sekundärseitige Schaltung 102 und 104 separat aufgebaut. Dabei kann die primärseitige Schaltung 102 eine Mehrschichtstruktur von übereinandergestapelten Keramiksubstraten sein, in die integrierte Kondensatoren, wie in den Figuren 5 bis 8 gezeigt, eingebettet sind. Die einzelnen Schichten werden über ein gemeinsames Sintern, einen Klebevorgang oder ein Verlöten mechanisch zusammengehalten.

In einem nächsten Arbeitsschritt werden diskrete Bauelemente 108, 120 aufgebracht und beispielsweise durch Verlöten elektrisch kontaktiert.

Die sekundärseitige Schaltung 104 kann z. B. durch ein Leadframe 122 gebildet sein, auf dem ebenfalls diskrete Bauelemente 124 aufgebracht sind. Nunmehr wird die primärseitige Schaltung mechanisch und elektrisch mit einem Wandler 106 verbunden. An dem Wandler ist eine Isolationsschicht 126 vorgesehen, an welcher der Leadframe 122 mit der sekundärseitigen Schaltung montiert wird.

Um die für die elektrische Sicherheit erforderlichen Luft- und Kriechstrecken möglichst gering zu halten, kann die Leistungsversorgungsschaltung optional auch vergossen werden.

Die gesamte Leistungsversorgungsschaltung 100 kann schließlich noch mit einer Grundplatte verbunden werden. Eine weitere Umhüllung, beispielsweise aus einem elektrisch isolierenden Kunststoff, kann abschließend für die benötigte Stabilität und eine verbesserte elektrische Isolation sorgen.

## Patentansprüche

1. Leistungsversorgungsschaltung mit mindestens einem Wandler (106), der mit einem primärseitigen Schaltkreis (102) und mit einem sekundärseitigen Schaltkreis (104) verbunden ist,
wobei der primärseitige Schaltkreis (102) und der sekundärseitige Schaltkreis (104) auf jeweils mindestens einem separaten Schaltungsträger (110, 114, 118, 122), die mechanisch und elektrisch miteinander gekoppelt sind, aufgebaut sind und wobei die Schaltungsträger in mindestens zwei verschiedenen Ebenen angeordnet sind,
**dadurch gekennzeichnet,**
**dass** die durch den mindestens einen sekundärseitigen Schaltungsträger (122) definierte Ebene im wesentlichen quer zu der durch den mindestens einen primärseitigen Schaltungsträger (110, 114, 118) definierten Ebene verläuft.

2. Leistungsversorgungsschaltung mit mindestens einem Wandler (106), der mit einem primärseitigen Schaltkreis (102) und mit einem sekundärseitigen Schaltkreis (104) verbunden ist,
wobei der primärseitige Schaltkreis (102) und der sekundärseitige Schaltkreis (104) auf jeweils mindestens einem separaten Schaltungsträger (110, 114, 118, 122), die mechanisch und elektrisch miteinander gekoppelt sind, aufgebaut sind und wobei die Schaltungsträger in mindestens zwei verschiedenen Ebenen angeordnet sind,
**dadurch gekennzeichnet,**
**dass** der primärseitige Schaltkreis (102) auf einer Vielzahl von primärseitigen Schaltungsträgern (110, 114, 118), deren Ebenen im wesentlichen parallel zueinander verlaufen, aufgebaut ist.

3. Leistungsversorgungsschaltung nach einem der Ansprüche 1 oder 2, **dadurch gekennzeichnet, dass** der mindestens eine primärseitige Schaltungsträger (110, 114, 118) durch eine elektrisch isolierende Schicht (126) von dem mindestens einen sekundärseitigen Schaltungsträger (122) getrennt ist.

4. Leistungsversorgungsschaltung nach einem der Ansprüche 1 bis 3, **dadurch gekennzeichnet, dass** mindestens einer der Schaltungsträger (110) integrierte Widerstände, die vorzugsweise in Dickschichttechnologie herstellbar sind, umfasst.

5. Leistungsversorgungsschaltung nach einem der Ansprüche 1 bis 4, **dadurch gekennzeichnet, dass** mindestens einer der Schaltungsträger (114) integrierte Kondensatoren mit mittlerer Spannungsfestigkeit aufweist.

6. Leistungsversorgungsschaltung nach einem der Ansprüche 1 bis 5, **dadurch gekennzeichnet, dass** mindestens einer der Schaltungsträger (118) integrierte Kondensatoren mit hoher Spannungsfestigkeit aufweist.

7. Leistungsversorgungsschaltung nach Anspruch 5 oder 6, **dadurch gekennzeichnet, dass** die integrierten Kondensatoren als Monolayerstruktur herstellbar sind.

8. Leistungsversorgungsschaltung nach Anspruch 5 oder 6, **dadurch gekennzeichnet, dass** die integrierten Kondensatoren als Multilayerstruktur herstellbar sind.

9. Leistungsversorgungsschaltung nach Anspruch 5 oder 6, **dadurch gekennzeichnet, dass** die integrierten Kondensatoren durch Einbringen einer Dielektrikumvorstufe in Aussparungen des Schaltungsträgers herstellbar sind.

10. Leistungsversorgungsschaltung nach einem der Ansprüche 1 bis 9, **dadurch gekennzeichnet, dass** mindestens einer der Schaltungsträger (110, 114, 118, 122) diskrete aktive und/oder passive Bauelemente aufweist.

11. Leistungsversorgungsschaltung nach einem der Ansprüche 1 bis 10, **dadurch gekennzeichnet, dass** der Wandler (106) ein elektromagnetischer Wandler ist.

12. Leistungsversorgungsschaltung nach einem der Ansprüche 1 bis 10, **dadurch gekennzeichnet, dass** der Wandler (106) ein piezoelektrischer Wandler ist.

13. Leistungsversorgungsschaltung nach einem der Ansprüche 1 bis 12, **dadurch gekennzeichnet, dass** mindestens einer der Schaltungsträger (110, 114, 118, 122) aus einem keramischen Werkstoff herstellbar ist.

14. Leistungsversorgungsschaltung nach einem der Ansprüche 1 bis 13, **dadurch gekennzeichnet, dass** mindestens einer der Schaltungsträger (110, 114, 118, 122) so ausgebildet ist, dass er bei Betrieb entstehende Verlustwärme nach außen abführt.

15. Leistungsversorgungsschaltung nach einem der Ansprüche 1 bis 14, **dadurch gekennzeichnet, dass** die einzelnen Schaltungsträger (110, 114, 118, 122) mittels eines gemeinsamen Sinterns, Klebens oder Verlötens miteinander mechanisch verbindbar sind.

16. Leistungsversorgungsschaltung nach einem der Ansprüche 1 bis 15, **dadurch gekennzeichnet, dass** die einzelnen Schaltungsträger über Durchkontaktierungen in mindestens einer Isolationsschicht (112) elektrisch miteinander verbindbar sind.

17. Leistungsversorgungsschaltung nach einem der Ansprüche 1 bis 16, **dadurch gekennzeichnet, dass** sie wenigstens teilweise von einer elektrisch isolierenden Umhüllung umgeben ist.

18. Leistungsversorgungsschaltung nach Anspruch 17, **dadurch gekennzeichnet, dass** die elektrisch isolierende Umhüllung durch eine Vergussmasse gebildet ist.

19. Leistungsversorgungsschaltung nach Anspruch 11, **dadurch gekennzeichnet, dass** in einem Spulenkörper des Wandlers (106) elektrische Bauteile integriert sind.

20. Leistungsversorgungsschaltung nach Anspruch 12, **dadurch gekennzeichnet, dass** in einer Wandlerhalterung des Wandlers (106) elektrische Bauteile integriert sind.

21. Verfahren zum Herstellen einer Leistungsversorgungsschaltung mit mindestens einem Wandler, einer primärseitigen Schaltung und einer sekundärseitigen Schaltung, wobei das Verfahren die folgenden Schritte aufweist:
Aufbauen der primärseitigen Schaltung auf mindestens einem primärseitigen Schaltungsträger;
Aufbauen der sekundärseitigen Schaltung auf mindestens einem separaten sekundärseitigen Schaltungsträger;
elektrisches und mechanisches Koppeln der Schaltungsträger mit dem Wandler, wobei die Schaltungsträger in mindestens zwei verschiedenen Ebenen angeordnet sind,
**dadurch gekennzeichnet,**
**dass** die durch den mindestens einen sekundärseitigen Schaltungsträger definierte Ebene im wesentlichen quer zu der durch den mindestens einen primärseitigen Schaltungsträger definierten Ebene verläuft.

22. Verfahren zum Herstellen einer Leistungsversorgungsschaltung mit mindestens einem Wandler, einer primärseitigen Schaltung und einer sekundärseitigen Schaltung, wobei das Verfahren die folgenden Schritte aufweist:
Aufbauen der primärseitigen Schaltung auf einer Vielzahl von primärseitigen Schaltungsträgern, deren Ebenen im wesentlichen parallel zueinander verlaufen;
Aufbauen der sekundärseitigen Schaltung auf mindestens einem separaten sekundärseitigen Schaltungsträger;
elektrisches und mechanisches Koppeln der Schaltungsträger mit dem Wandler, wobei die primärseitigen und sekundärseitigen Schaltungsträger in mindestens zwei verschiedenen Ebenen angeordnet sind.

## Claims

1. Power supply circuit with at least one transformer (106) which is connected to a primary side circuit (102) and to a secondary side circuit (104),
wherein the primary side circuit (102) and the secondary side circuit (104) are each mounted on at least one separate circuit carrier (110, 114, 118, 122), said circuit carriers being coupled with one another mechanically and electrically and being arranged in at least two different planes,
**characterized in**
**that** the plane which is defined by the at least one secondary side circuit (122) extends in<a direction substantially transverse to the plane defined by the at least one primary side circuit carrier (110, 114, 118).

2. Power supply circuit with at least one transformer (106) which is connected to a primary side circuit (102) and to a secondary side circuit (104),
wherein the primary side circuit (102) and the secondary side circuit (104) are each mounted on at least one separate circuit carrier (110, 114, 118, 122), said circuit carriers being coupled with one another mechanically and electrically and being arranged in at least two different planes,
**characterized in**
**that** the primary side circuit (102) is mounted on a plurality of primary side circuit carriers (110, 114, 118), the planes of which are substantially parallel to each other.

3. Power supply circuit according to one of the claims 1 or 2, **characterized in that** the at least one primary side circuit carrier (110, 114, 118) is separated by an electrically insulating layer (126) from the at least one secondary side circuit carrier (122).

4. Power supply circuit according to one of the claims 1 to 3, **characterized in that** at least one of the circuit carriers (110) comprises integrated resistors which can preferably be produced by thick film technology.

5. Power supply circuit according to one of the claims 1 to 4, **characterized in that** at least one of the circuit carriers (114) comprise integrated capacitors having a medium dielectric strength.

6. Power supply circuit according to one of the claims 1 to 5, **characterized in that** at least one of the circuit carriers (118) comprises integrated capacitors having high dielectric strength.

7. Power supply circuit according to claim 5 or 6, **characterized in that** the integrated capacitors can be produced as a monolayer structure.

8. Power supply circuit according to claim 5 or 6, **characterized in that** the integrated capacitors can be produced as a multilayer structure.

9. Power supply circuit according to claim 5 or 6, **characterized in that** the integrated capacitors can be produced by introducing a dielectric precursor into recesses of the circuit carrier.

10. Power supply circuit according to one of the claims 1 to 9, **characterized in that** at least one of the circuit carries (110, 114, 118, 122) comprises discrete active and/or passive components.

11. Power supply circuit according to one of the claims 1 to 10, **characterized in that** the transformer (106) is an electromagnetic transformer.

12. Power supply circuit according to one of the claims 1 to 10, **characterized in that** the transformer (106) is a piezoelectric transformer.

13. Power supply circuit according to one of the claims 1 to 12, **characterized in that** at least one of the circuit carriers (110, 114, 118, 122) can be produced from a ceramic material.

14. Power supply circuit according to one of the claims 1 to 13, **characterized in that** at least one of the circuit carriers (110, 114, 118, 122) is designed in a way that it discharges dissipated heat produced during operation to the outside.

15. Power supply circuit according to one of the claims 1 to 14, **characterized in that** the individual circuit carriers (110, 114, 118, 122) are mechanically connectable to one another by means of joint sintering, adhesive bonding or soldering.

16. Power supply circuit according to one of the claims 1 to 15, **characterized in that** the individual circuit carrier are mechanically connectable to one another by means of vias in at least one insulation layer (112).

17. Power supply circuit according to one of the claims 1 to 16, **characterized in that** same is at least partially surrounded by an electrically insulating coating.

18. Power supply circuit according to claim 17, **characterized in that** the electrically insulating coating is formed by a casting material.

19. Power supply circuit according to claim 11, **characterized in that** electric components are integrated into a coil body of the transformer (106).

20. Power supply circuit according to claim 12, **characterized in that** electric components are integrated into a transformer mounting of the transformer (106).

21. Method for producing a power supply circuit with at least one transformer, a primary side circuit and a secondary side circuit, said method comprising the following steps:
mounting the primary side circuit on at least one primary side circuit carrier;
mounting the secondary side circuit on at least one separate secondary side circuit carrier;
electrically and mechanically coupling the circuit carriers with the transformer, the circuit carriers being arranged in at least two different planes,
**characterized in**
**that** the plane defined by the at least one secondary side circuit carrier extends in a direction substantially transverse to the plane defined by the at least one primary side circuit carrier.

22. Method for producing a power supply circuit with at least one transformer a primary side circuit and a secondary side circuit, said method comprising the following steps:
mounting the primary side circuit on a plurality of primary side circuit carriers, wherein the planes of these circuit carriers are substantially parallel to each other;
mounting a secondary side circuit on at least one separate secondary side circuit carrier;
electrically and mechanically coupling said circuit carriers with the transformer, wherein the primary side and the secondary side circuit carriers are arranged in at least two different planes.

## Revendications

1. Circuit d'alimentation en puissance avec au moins un convertisseur (106) qui est relié à un circuit côté primaire (102) et à un circuit côté secondaire (104),
le circuit côté primaire (102) et le circuit côté secondaire (104) étant construits respectivement sur au moins un support de circuits séparé (110, 114, 118, 122), lesquels sont couplés ensemble mécaniquement et électriquement, et les supports de circuits étant agencés dans au moins deux plans différents,
**caractérisé en ce,**
**que** le plan défini par le au moins un support de circuits côté secondaire (122) s'étend essentiellement transversalement au plan défini par le au moins un support de circuits côté primaire (110, 114, 118).

2. Circuit d'alimentation en puissance avec au moins un convertisseur (106) qui est relié à un circuit côté primaire (102) et à un circuit côté secondaire (104),
le circuit côté primaire (102) et le circuit de côté secondaire (104) étant construits respectivement sur au moins un support de circuits séparé (110, 114, 118, 122), lesquels sont couplés ensemble mécaniquement et électriquement, et les supports de circuits étant agencés dans au moins deux plans différents,
**caractérisé en ce que**,
le circuit côté primaire (102) est monté sur une pluralité de supports de circuits côté primaire (110, 114, 118) dont les plans s'étendent essentiellement parallèlement les uns aux autres.

3. Circuit d'alimentation en puissance selon l'une des revendications 1 ou 2, **caractérisé en ce que** le au moins un support de circuits côté primaire (110, 114, 118) est séparé du au moins un support de circuits côté secondaire (122) par une couche électriquement isolante (126).

4. Circuit d'alimentation en puissance selon l'une des revendications 1 à 3, **caractérisé en ce qu'**au moins un des supports de circuits (110) comporte des résistances intégrées qui peuvent être fabriquées de préférence en technologie des couches épaisses.

5. Circuit d'alimentation en puissance selon l'une des revendications 1 à 4, **caractérisé en ce qu'**au moins un des supports de circuits (114) présente des condensateurs intégrés avec rigidité diélectrique moyenne.

6. Circuit d'alimentation en puissance selon l'une des revendications 1 à 5, **caractérisé en ce qu'**au moins un des supports de circuits (118) présente des condensateurs intégrés avec rigidité diélectrique élevée.

7. Circuit d'alimentation en puissance selon la revendication 5 ou 6, **caractérisé en ce que** les condensateurs intégrés peuvent être fabriqués comme une structure monocouche.

8. Circuit d'alimentation en puissance selon la revendication 5 ou 6, **caractérisé en ce que** les condensateurs intégrés peuvent être fabriqués en structure multicouche.

9. Circuit d'alimentation en puissance selon la revendication 5 ou 6, **caractérisé en ce que** les condensateurs intégrés peuvent être fabriqués par la mise en place d'un étage préliminaire diélectrique dans des évidements du support de circuit.

10. Circuit d'alimentation en puissance selon l'une des revendications 1 à 9, **caractérisé en ce qu'**au moins un des supports de circuits (110, 114, 118, 122) présente des composants électroniques discrets actifs et/ou passifs.

11. Circuit d'alimentation en puissance selon l'une des revendications 1 à 10, **caractérisé en ce que** le convertisseur (106) est un convertisseur électromagnétique.

12. Circuit d'alimentation en puissance selon l'une des revendications 1 à 10, **caractérisé en ce que** le convertisseur (106) est un convertisseur piézoélectrique.

13. Circuit d'alimentation en puissance selon l'une des revendications 1 à 12, **caractérisé en ce qu'**au moins un des supports de circuits (110, 114, 118, 122) peut être fabriqué en matériau céramique.

14. Circuit d'alimentation en puissance selon l'une des revendications 1 à 13, **caractérisé en ce qu'**au moins un des supports de circuits (110, 114, 118, 122) est formé de telle manière qu'il évacue à l'extérieur des pertes thermiques survenues en cours de fonctionnement.

15. Circuit d'alimentation en puissance selon l'une des revendications 1 à 14, **caractérisé en ce que** les supports de circuits individuels (110, 114, 118, 122) peuvent être reliés mécaniquement les uns aux autres au moyen d'un frittage, d'un collage ou d'un brasage commun.

16. Circuit d'alimentation en puissance selon l'une des revendications 1 à 15, **caractérisé en ce que** les supports de circuits individuels peuvent être reliés électriquement les uns aux autres par le biais de métallisation de trous dans au moins une couche isolante (112).

17. Circuit d'alimentation en puissance selon l'une des revendications 1 à 16, **caractérisé en ce qu'**il est entouré au moins partiellement par un enrobage électriquement isolant.

18. Circuit d'alimentation en puissance selon la revendication 17, **caractérisé en ce que** l'enrobage électriquement isolant est formé par une masse de remplissage.

19. Circuit d'alimentation en puissance selon la revendication 11, **caractérisé en ce que** des composants électriques sont intégrés dans une armature de bobine du convertisseur (106).

20. Circuit d'alimentation en puissance selon la revendication 12, **caractérisé en ce que** des composants électriques sont intégrés dans une embase de convertisseur du convertisseur (106).

21. Procédé de fabrication d'un circuit d'alimentation en puissance avec au moins un convertisseur, un circuit côté primaire et un circuit côté secondaire, le procédé présentant les étapes suivantes :
construction du circuit côté primaire sur au moins un support de circuits côté primaire,
construction du circuit côté secondaire sur au moins un support de circuits séparé côté secondaire,
couplage électrique et mécanique des supports de circuits au convertisseur, les supports de circuits étant agencés dans au moins deux plans différents,
**caractérisé en ce,**
**que** le plan défini par le au moins un support de circuits côté secondaire s'étend essentiellement transversalement au plan défini par le au moins un support de circuits côté primaire.

22. Procédé de fabrication d'un circuit d'alimentation en puissance avec au moins un convertisseur, un circuit côté primaire et un circuit côté secondaire, le procédé présentant les étapes suivantes :
construction d'un circuit côté primaire sur une pluralité de supports de circuits côté primaire, dont les plans s'étendent essentiellement parallèlement les uns aux autres ;
construction d'un circuit côté secondaire sur au moins un support de circuits côté secondaire séparé ;
couplage électrique et mécanique des supports de circuits au convertisseur, les supports de circuits côté primaire et côté secondaire étant agencés dans au moins deux plans différents.
